Europäisches Patentamt

European Patent Office

Office européen des brevets

(11) Publication number: **0 520 434 A1**

# EUROPEAN PATENT APPLICATION

(21) Application number: **92110686.0**

(22) Date of filing: **25.06.92**

(51) Int. Cl.⁵: **H05K 3/46**

(30) Priority: **26.06.91 US 721735**

(43) Date of publication of application:
**30.12.92 Bulletin 92/53**

(84) Designated Contracting States:
**CH DE ES FR GB IT LI SE**

(71) Applicant: **Hughes Aircraft Company**
**7200 Hughes Terrace P.O. Box 45066**
**Los Angeles, California 90045-0066(US)**

(72) Inventor: **Gulick, Jon J.**
**5537 West 124th Street**
**Hawthorne, California 90250(US)**
Inventor: **Shoda, Craig K.**
**16201 Wilie Avenue**
**Torrance, California 90504(US)**

(74) Representative: **Witte, Alexander, Dr.-Ing. et al**
**Augustenstrasse 7**
**W-7000 Stuttgart 1(DE)**

(54) **Integrated socket-type package for flip chip semiconductor devices and circuits.**

(57) A multi-layer circuit board (11) has a configuration of traces (27) within the volume of the multi-layer circuit board (11) to facilitate mountable conductive contact with semiconductor chips (13) through holes (23) formed in the multi-layer circuit boards (11) which are filled with solder or conductive epoxy. Semiconductor chips (13) have an array of metallic posts (19) alignable with holes (23) and are mounted upon the upper surface of the multi-layer circuit board (11) in plug fashion. An aperture (25) may be formed in multi-layer circuit board (11) directly below each semiconductor chip (13) for protection of the circuitry on semiconductor chip (13) from contact with the multi-layer circuit board (11).

FIG. 1

## BACKGROUND OF THE INVENTION

### 1. Field of the Invention

The invention is related to a package and process for flip chip mounting and bonding onto a circuit board.

### 2. Description of Related Art

With increasing packaging density and device operation speed (digital) or operating frequency (analog), new challenges have been imposed in the field of electronic packaging. New packaging techniques such as tape automated bonding are quickly replacing wire bonding in many areas. The conventional packaging approach is a two step process. First, the semiconductor chip is attached (face-up fashion) to the substrate or metallic carrier using a conductive epoxy adhesive or eutectic solder bond. Second, the interconnect operation, wherein electrical continuity between the chip and the rest of the circuitry is established, is completed by wire bonds. Even with automated assembly procedures, this approach is time consuming and defect prone - missing or ineffective wire bonds, for instance. Flip chip bonding is a viable substitute for and utilizable in addition to tape automated bonding.

There are several ways to attach a die to a substrate. One common approach uses non-conductive or conductive epoxy for die to substrate attachment. In this technique, the die is glued to the substrate and the epoxy is cured for good die attach. A second method, which involves a eutectic die attach, is used in most military applications and in cases where heat conduction is important. A gold/tin solder preform on the substrate is brought in contact with the semiconductor and with the aid of temperature, about 360°C, the eutectic point is reached and attachment occurs. These techniques require gold or aluminum wires to be bonded on the output pads of the device. Due to the complexity of today's circuits, many output pads exist requiring many wires to be bonded. There also is the demand to attach more than one circuit on a substrate for space economy.

Early attempts to get away from wire bonding were successfully implemented with the beam lead technology in which thin gold leads protrude from the edge of the device via a special metallization process. The device is flipped over and a special wobbling tool attaches all the beams to substrate in one motion.

Another technique which is widely used is tape automated bonding. A special frame with the configuration of the output pads on the chip is placed over the chip. A heated bonding tool is lowered to apply pressure and temperature for thermocompression bonding. Another method of implementing this same idea is to use solder for frame attachment to the die. Tape automated bonding packaging fits very well with automation where a spool with the frame is moved over dies which are placed on a chuck.

The aforementioned packaging techniques do not fit well with multi-chip hybrid or chip on board packaging. There is a growing tendency to mount many chips on one substrate for increased density and increased operating speed of the device. Renewed interest has surfaced in the technique of flip chip bonding.

The heretofore conventional flip chip approach for packaging semiconductor devices has been previously used with integrated circuits and prior art for that approach can be found in the technical literature. Flip chip is just now emerging as a viable packaging approach for GaAs devices operating at microwave and millimeter wave frequencies. Flip chip bonding lends itself to high packaging densities, faster circuits, and eliminates wire bonding. Various methods to obtain reliable processes are being investigated by many corporations. In general, a metal bump is grown on the chip, the substrate, or both. The chip is flipped over, aligned to the substrate, and bonded. The "bumped" chip is elevated from the surface of the substrate by the height of the bumps and electrical connection occurs on the top layer. There are basically four different methods being investigated.

The most common method is the use of solder balls "grown" on the output pads of the die and the substrate. As mentioned before, the die is flipped over, aligned to the substrate, and bonded by heating the solder to the reflow point. Die alignment with the substrate is through the mechanism of the surface tension of the solder.

Gold bump to gold or aluminum pads are used in conjunction with thermocompression bonding. Heat and pressure are used to achieve a reliable contact between the die and the substrate. A variation on the theme can be the use of ultrasonic bonding of gold to gold after the alignment and contact.

Indium is also used for flip chip bonding. Indium is used mainly where cryogenic temperatures are required for the operation of the device. One of the main applications is for focal plane arrays and special detectors. Indium is deposited on the die and substrate by plating, or evaporation and lift-off technique to obtain the bumps.

Conductive epoxy also is utilizable for flip chip bonding. The epoxy can be screened on the substrate and the operation is similar to the process explained before.

One of the big problems facing the packaging process today is the mismatch between the substrate and the die. Alignment of the chip to the substrate depends on the surface tension forces in the solder during the reflow operation or placement accuracy if conductive epoxy is used. Additionally, in the case of solder, containment dams are required to prevent solder from wicking along the circuit traces during reflow. One solution to problem of alignment includes the possibility of using reflected IR illumination to look through the device and see the contacts on the flipped die and the substrate simultaneously, in conjunction with an IR autocollimator to ensure that the sample is parallel to the substrate. The normal flip chip approach, however, suffers disadvantages as well, especially when used with GaAs MMIC devices. The air gap between the chip and the substrate is difficult to control because it depends on both the bump height and the adhesive height (solder or conductive epoxy).

Unfortunately, the infrared flip chip alignment requires the back of the flip chip to be polished and not metallized. Open areas in the front metallization are required in order to be able to see the substrate. Furthermore, the resistivity of the flipped die has to be high enough to allow the IR light to penetrate. Most integrated circuits do not fulfill these requirements, and such light alignment system is expensive and cumbersome.

A circuitry system is needed which offers the savings of the flip chip system but with reliable alignment to insure proper connection. Control of the air gap between the chip and the mounting substrate is also needed especially with higher frequency systems.

## SUMMARY OF THE INVENTION

This invention utilizes a multi-layer circuit board or substrate and the semiconductor chip or chips. Metallic posts, or bumps, are formed at each input/output pad of a chip, typically by an electroplating process. This "bumped" chip is then mounted in flip chip fashion to the mating substrate, that is, with the circuit side of the chip and its array of bumps adjacent to the substrate.

An array of via holes is etched or drilled in the top layer or layers of the substrate and partially filled with either solder or conductive epoxy. The array of vias, so arranged as to be the mirror image of the array of bumps on the semiconductor chip, serves as a socket for the IC. The circuit traces that are required to mate with the chip are buried in the multi-layer substrate and terminate in the vias, thus establishing electrical continuity between the input/output pads on the chip and the circuit traces in the substrate.

This invention permits more than one device per substrate. Multiple chips, including a mixture of gallium arsenide millimeter wave integrated circuits, silicon IC's, and discrete devices, can all be integrated on a single substrate with the requisite mating sockets. Interconnection between these devices is accomplished with the buried circuit traces.

This invention eliminates each of these drawbacks of a normal flip chip. It features self-alignment of the chip to the substrate and a built-in solder or epoxy containment mechanism. Also, by cutting cavities in one or more layers of the multi-layer board directly below the chip, precise control of the air gap height is achieved.

## BRIEF DESCRIPTION OF THE DRAWINGS

In the accompanying drawings:
FIG. 1 is a perspective view of a multi-layer circuit board illustrating attachment and carriage of the semiconductor chip of the present invention including layout of the conductors;
FIG. 2 is a sectional view illustrating the multi-layer construction of the circuit board of FIG. 1; and,
FIG. 3 is an enlarged view of the sectional view of FIG. 2.

## DESCRIPTION OF THE PREFERRED EMBODIMENTS

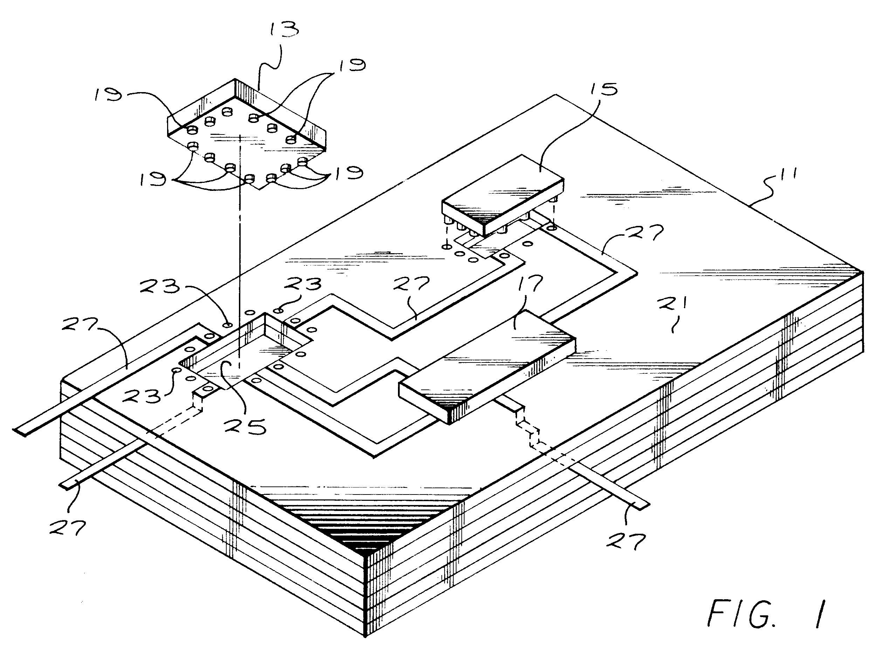

Referring to FIG. 1, a multi-layer circuit board 11 is illustrated in perspective view. Multi-layer circuit board 11 is shown sectionally about its periphery, and a series of horizontal lines illustrate the interstices representing the narrow spaces between the circuit board layers. A series of three semiconductor chips are shown in various stages of attachment, and are referred to generally with the reference numerals 13, 15 and 17, respectively.

Semiconductor chip 13 is illustrated high over multi-layer circuit board 11. On one side of semiconductor chip 13 are a series of metallic posts 19 distributed along the edges of semi-conductor chip 13. The metallic posts 19 may be formed by successive layers of electrode deposited metal, or electrodeposition. Alternatively, metallic posts 19 may be affixed by any known manner necessary to impart conductive attachment of metallic posts 19 with the circuitry of semiconductor chip 13. Semiconductor chip 13 contains circuitry as is well known for semiconductor chips based upon the location and interrelationship of doped silicon or gallium arsenide which is known in the art to produce transistors, diodes, and other circuit elements constructed therefrom.

Multi-layer circuit board 11 has an upper surface 21 into which are formed a series of holes 23 in a pattern matching the array of metallic posts 19 at the bottom of semiconductor chip 13. As is shown in dashed line format, semiconductor chip 13 is lowered toward the upper surface of multi-layer circuit board 11 in order to bring metallic posts 19 within their matching holes 23 formed in the upper surface 21 of multi-layer circuit board 11.

In this manner, the semiconductor chips 13, 15 and 17 are initially mounted in "socket" fashion. The "sockets" are formed in a section of a multi-layer circuit board with the formation of holes 23. Before attachment of the semiconductor chips 13, 15 and 17 are mounted, solder or conductive epoxy is deposited into each hole 23. The chips are then plugged into the holes 23 much as a common Dual In-line Package integral circuit would be plugged into a standard socket.

Note that an aperture 25 is formed in the upper two layers of multi-layer circuit board 11. Note that aperture 25 has a rectangular shape generally matching the rectangular shape of semiconductor chip 13 and has edges extending adjacent to holes 23.

As is somewhat more readily shown with regard to semiconductor chip 15, the body of the semiconductor chip 15 fits over the aperture 25 formed in the upper two layers of the multi-layer circuit board 11. The degree of overlap of semiconductor chips 13, 15 and 17 onto multi-layer circuit board 11 is practiced to the extent necessary to support the semiconductor chips 13, 15 and 17, and to provide enough material about holes 23 to ensure that any conductive material within holes 23 remains isolated and securely intact.

It is understood that aperture 25, upon mounting of the semiconductor chips 13, 15 and 17, forms an air gap to provide an adjacent volume. In order to prevent the substrate from coming into contact with the delicate circuitry on the surface of the semiconductor chips 13, 15 and 17, aperture 25 allows a sufficient clearance. At those locations where contact between the semiconductor chips 13, 15 and 17 and the substrate does occur only non-fragile circuit components are present. It is to be understood that the volume of the air gap may be increased or decreased by extending aperture 25 into greater numbers of successive layers of multi-layer circuit board 11. The two apertures 25 illustrated are two layers deep; however they may be made one, three, or more layers deep as are necessary to ensure proper operation of semiconductor chips 13, 15 and 17.

For many devices, particularly GaAs MMIC devices, the air gap height $H_G$ dimension is determined by the number of layers through which the cavity is formed. Since the thickness of each layer can be precisely controlled the overall air gap height $H_G$ is also controlled.

In the case of FIG. 1, the general shape of aperture 25 matches the general shape of semi-conductor chips 13, 15 and 17. It is to be understood, however, that the aperture 25 may be of any shape necessary to provide the proper air gap volume and spacing. It is anticipated that proper volume and spacing will depend upon the circuit densities and requirements of those circuits on semiconductor chips 13, 15 and 17.

In communication with holes 23, a series of traces, or conductive traces 27 extend between the layers of multi-layer circuit board 11, and at some level they approach one of holes 23. The buried circuit conductive traces provide an interconnection between the mounted semiconductor chips 13, 15 and 17 and the rest of the circuitry in multilayered circuit board 11. As will be later shown, the ends of conductive traces 27 which terminate within the boundary of multi-layer circuit board 11 are in communication with holes 23. As will be the case in a typical circuit system, some of the conductive traces 27 extend between one or more of the semiconductor chips 13, 15 and 17, while other of the conductive traces 27 extend to points off of the multi-layer circuit board 11 boundary.

Note that semiconductor chip 17 is in its fully supported and mounted position. Semiconductor chip 17 is vertically supported by the upper surface 21 of multi-layer circuit board 11. Semiconductor chip 17, similar to those shown for semiconductor chips 13 and 15, has a series of metallic posts 19 (not shown for semiconductor chip 17) which are in conductive contact with conductive traces 27. The metallic posts 19 of semiconductor chip 17, which extend into holes 23 of multi-layer circuit board 12, lend further lateral support to the mounting integrity of semiconductor chip 17.

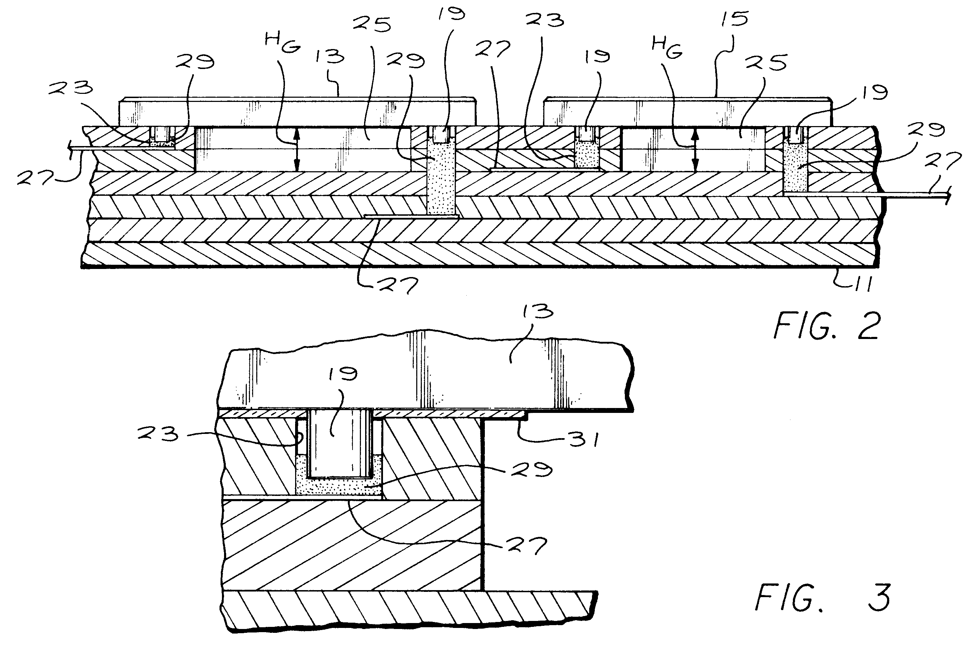

Referring to FIG. 2, an enlarged sectional view of the multi-layer circuit board 11 of FIG. 1 is illustrated. Semi-conductor chips 13 and 15 are shown in their fully mounted positions. In mounted position, note that each of the metallic posts 19 extend partially into the holes 23. Note that the conductive traces 27 are exposed at the bottom of holes 23. Note that the exposure of the conductive traces 27 at the bottom of holes 23 may occur at differing levels within multi-layer circuit board 11 to facilitate the advantageous routing of such conductors.

To complete contact between the metallic posts 19 and that portion of the conductive traces 27 exposed at the bottom of holes 23, a conductive filler material 29 is provided in holes 23 sufficient to ensure contact between metallic posts 19 and conductive traces 27. Conductive filler material 29 may be either a conductive epoxy or any suitable type of solder.

Referring to FIG. 3, a closeup of the sectional view of FIG. 2 is further illustrated. Note that enough conductive filler material 29 must exist within hole 23 to ensure sufficient contact between the conductive traces 27 exposed at the base of hole 23 and the bottom and lower side surfaces of metallic posts 19. Pursuant to this goal, it is clear that holes 23 must be adequately filled with conductive filler material 29 in order that good contact is made, but not overly filled such that the conductive filler material 29 is forced out of hole 23 by virtue of the displacement of metallic post 19. Displacement of the conductive filler material 29 could cause contact between adjacent metallic posts 19 as well as form a planar conductor in the intersticial area between the bottom surface of semiconductor chip 13 and the upper surface 21 of multi-layer circuit board 11.

In addition, the embodiment of FIG. 3 illustrates a dielectric, or glass passivation layer 31 applied adjacent the bottom layer of semiconductor chips 13, 15 and 17. Glass passivation layer 31 acts to protect those circuit components and conductive traces 27 at or adjacent the bottom layer of semiconductor chips 13, 15 and 17 which otherwise come into touching contact with the upper surface 21 of multi-layer circuit board 11. In typical applications, protection of the traces is provided by a glass passivation layer on the semiconductor chip. All fragile circuit features, such as the air bridges, are situated over the cavity. In addition, and as an option, the glass passivation layer 31 can be dimensionally toleranced to a very close fit around metallic posts 19 to inhibit the flow of conductive filler material from making contact with any portion of the lower surface of semiconductor chips 13, 15 and 17.

This invention enjoys many advantages over the conventional approach for packaging semiconductor chips. This invention accomplishes semiconductor chip 13 attachment and interconnect simultaneously, leading to reduced assembly cycle time and reduced cost. This resulting multilayered circuit board 11 package results in higher reliability than the conventional package since the inherently unreliable wire bonds have been eliminated. Better performance and repeatability are other important advantages of this invention because the wire bonds, with their associated inductance variations, have been replaced by highly consistent and reliable electroplated metallic posts.

This invention has wide applicability to both military and commercial product lines. Radar transmit/receive modules represent a primary target application for this invention. It has been determined that in order for the transmit/receive module to be affordable and reliable, the wire bond interconnect must be eliminated. More generally, for any situation where semiconductor devices are used, improved reliability, reduced cost, reduced cycle time and improved performance are possible through the use of this invention. These features are beneficial to both military and commercial applications.

Another advantage of this invention has to do with the containment of the solder or epoxy. In typical flip chip applications one must provide some type of containment mechanism that prevents the solder or epoxy from wicking along the circuit traces or flowing away from the input/output pad. This mechanism usually takes the form of a layer of dielectric material deposited across the circuit traces or an annular ring of dielectric material that encircles each input/output pad. In this invention the containment feature is built-in, since the solder or epoxy is deposited into the holes 23 in the substrate.

Finally, no special alignment methods are required with this invention. Once the semiconductor chips 13, 15 and 17 are plugged into the multi-layer circuit board 11, it is captured and any subsequent solder reflow or epoxy curing operations can be performed without having to maintain this alignment. In fact, all chips in the assembly can be plugged into their respective sockets and heated to reflow the solder or to cure the epoxy for all the devices at the same time.

The foregoing disclosure and description of the invention are illustrative and explanatory thereof, and various changes in the dimensioning, materials of construction and method for mounting the semiconductor chips, as in the details of the illustrated construction, may be made without departing from the spirit and scope of the invention.

## Claims

1. A circuit, characterized by:
   - a circuit board (11) having conductive traces (27) extending through its volume, and a series of holes (23) extending from a surface (21) of the circuit board (11) into its volume a sufficient length to expose a portion of its associated conductive trace (27);
   - a conductive material (29) in each of said series of holes (23); and
   - a semiconductor chip (13, 15, 17) having a series of metallic posts (19) extending into said holes (23), the metallic posts (19) being in contact with said conductive material (29) thereby making electrical connection to the traces (27).

2. The circuit of claim 1, characterized in that said conductive material (29) is solder.

3. The circuit of claim 1, characterized in that said conductive material (29) is a conductive epoxy.

4.  The circuit of any of claims 1 - 3, characterized in that said metallic posts (19) are electrodeposited.

5.  The circuit of any of claims 1 - 4, characterized in that said circuit board (11) defines a cavity (25) adjacent said semiconductor chip (13, 15, 17).

6.  The circuit of claim 5, characterized in that the cavity (25) extends between the holes (23) and underneath the majority of the area of the chip (13, 15, 17) to thereby provide an air gap for isolating major portions of the chip (13, 15, 17) from the circuit board (11).

7.  The circuit of any of claims 1 - 6, characterized in that a dielectric passivation layer (31) extends between said semiconductor chip (13, 15, 17) and said circuit board (17).

8.  The circuit of claim 7, characterized in that said dielectric passivation layer (31) is made of glass.

9.  The circuit of any of claims 1 - 8, characterized by a plurality of said semiconductor chips (13, 15, 17) on said circuit board (11).

10. The circuit of any of claims 1 - 9, characterized in that said board (11) is a multilayered circuit board.

11. A process for mounting a chip (13, 15, 17) having input-output pads onto a substrate comprising the steps of:
    -   forming a substrate having conductive traces (27) extending through its volume;
    -   forming metallic posts (19) on the input-output pads of said chip (13, 15, 17);
    -   forming a series of holes (23) in the substrate to access the conductive traces (27) and in a pattern matching said metallic posts (19) of said chip (13, 15, 17);
    -   placing in the holes (23) of the substrate a conductive material (29) in electrical conduct with said traces (27); and
    -   mounting said chip (13, 15, 17) on said substrate by aligning said metallic posts (19) of said chip (13, 15, 17) within said holes (23) of said substrate.

12. The process of claim 11, characterized in that the metallic posts (19) are formed by electroplating.

13. The process of claim 11 or 12, characterized in that the substrate is a multi-layered circuit board (11).

14. The process of claim 13, characterized in that the circuit board (11) is multilayered and that said conductive traces (27) extend between said layers of said circuit board (11).

15. The process of any of claims 11 - 14, characterized in that said conductive material (29) is conductive epoxy.

16. The process of any of claims 11 - 14, characterized in that said conductive material (29) is a solder.

17. The process of claim 16, characterized by the step of heating the substrate to form a solder connection between the posts (19) of the chip (13, 15, 17) and the conductive traces (27).

18. The process of any of claims 11 - 17, characterized by the step of forming a cavity (25) in said substrate open to the exterior of said substrate, and wherein said chip (13, 15, 17) is mounted on said substrate over said cavity (25).

19. The process of any of claims 11 - 18, characterized by the step of placing a dielectric passivation layer (31) adjacent said semiconductor chip (13, 15, 17) before said mounting step.

FIG. 1

EP 0 520 434 A1

FIG. 2

FIG. 3

EP 0 520 434 A1

**EUROPEAN SEARCH REPORT**

EP 92110686.0

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GB - A - 2 204 184 (BRACEY) * Abstract; fig. 5-7; claims 1-16 * | 1,11 | H 05 K 3/46 |
| A | EP - A - 0 050 903 (DU PONT) * Abstract; claims 1-10; fig. 1-5 * | 1,11 | |
| A | EP - A - 0 052 738 (CONTRAVES) * Abstract; fig. 1 * | 1,11 | |
| A | EP - A - 0 183 936 (CONTRAVES) * Abstract; fig. 1,2; claims 1-4 * | 1,11 | |

TECHNICAL FIELDS SEARCHED (Int. Cl.5)

H 05 K 1/00
H 05 K 3/00

The present search report has been drawn up for all claims

| Place of search | Date of completion of the search | Examiner |
|---|---|---|
| VIENNA | 28-09-1992 | VAKIL |

EPO FORM 1503 03.82 (P0401)